# EUROPÄISCHE PATENTSCHRIFT

(11) **EP 2 555 003 B1**
(45) Veröffentlichungstag und Bekanntmachung des Hinweises auf die Patenterteilung: **04.01.2017**
(21) Anmeldenummer: 12177691.8
(22) Anmeldetag: 24.07.2012
(51) Int. Cl.: G01R 15/14, G01R 15/18, H01F 38/32, H01H 85/30

(54) **Stromwandler sowie Lasttrenner mit einem solchen**
Current transducer and load separator with same
Transducteur de courant et sectionneur de charge étant équipé avec celui-ci

(30) Priorität: 05.08.2011 DE 102011052449
(43) Veröffentlichungstag der Anmeldung: 06.02.2013
(73) Patentinhaber: EFEN GmbH, 65344 Eltville (DE)
(72) Erfinder: Schröder, Martin, 65343 Eltville (DE); Sandhäger, Ludger, 67813 Gerbach (DE)
(74) Vertreter: WSL Patentanwälte Partnerschaft mbB

(56) Entgegenhaltungen:
- EP-A1- 0 696 829
- EP-A1- 2 181 907
- EP-A2- 2 053 627
- EP-A2- 2 259 284
- DE-C1- 10 031 964
- DE-U1- 20 304 461

## Beschreibung

Die vorliegende Erfindung betrifft NH-Sicherungslasttrenner oder NH-Sicherungslastschaltleisten mit einem Gehäuse mit einer Bodenfläche und mindestens einem Einspeisekontakt sowie mindestens einem Abgangskontakt.

Solche Spannungs-Hochleistungs-(NH)-Sicherungslasttrenner oder NH-Sicherungslastschalt-leisten sind seit langem bekannt und dienen dazu, abgesicherte Abgänge von Sammelschienen bereitzustellen, die unter Last getrennt werden können. Die Einrichtungen weisen im Allgemeinen ein oder mehrere Sicherungsunterteile auf, die im Gehäuse angeordnet sind. Entsprechende Sicherungseinsätze sind beispielsweise an einem Schaltdeckel montiert, sodass bei geschlossenem Schaltdeckel die Sicherungseinsätze in den Sicherungsunterteilen eingesetzt sind und eine Verbindung zwischen den jeweiligen - mit den Sammelschienen verbindbaren - Einspeisekontakten und den Abgangskontakten herstellt. Beim Öffnen des Schaltdeckels werden die Sicherungseinsätze aus den Sicherungsunterteilen gezogen, sodass die Verbindung unterbrochen ist.

Grundsätzlich kann die vorliegende Erfindung auch bei offenen Verteilerleisten eingesetzt werden, bei denen die Sicherungseinsätze mit einem geeigneten Werkzeug aus dem offenen Gehäuse gezogen werden können. Der Begriff NH-Sicherungsschaltleiste soll daher auch die offenen Verteilerleisten umfassen.

Für manche Anwendungszwecke ist eine Messung des Stromflusses über den bereitgestellten Abgang erwünscht. Dazu werden meist Stromwandler eingesetzt. Stromwandler arbeiten wie Transformatoren, d.h. ein durch den Abgangsanschluss (Primärleiter) fließender Wechselstrom induziert in einem vom Stromwandler bereit gestellten Sekundärleiter einen vom Primärkreis galvanisch getrennten Sekundärstrom, der zur Messung des Primärstroms ausgewertet werden kann. Somit erfolgt die Messung berührungslos.

Es sind beispielsweise Aufsteck-Stromwandler bekannt, die einen Primärleiter (beispielsweise in Form eines elektrisch leitfähigen Zylinderteils) und einen diesen umgebenden Sekundärleiter aufweisen. Bei der Montage wird der Stromwandler auf dem Einspeisekontakt montiert, sodass der Primärleiter den Einspeisekontakt kontaktiert und der Primärleiter des Stromwandlers den durch den Einspeisekontakt fließenden Strom aufnimmt.

Den bekannten Stromwandlersystemen ist gemeinsam, dass der Anschluss des Sekundärleiters an entsprechende Auswertungseinrichtungen mühselig ist, da jeder Stromwandler mittels zweier Anschlusskabel angeschlossen werden muss und gleichzeitig eine kurzschlusssichere Verlegung zu gewährleisten ist.

Es ist daher für die eingangs genannten NH-Sicherungslastschaltleisten in der DE 10 2007 051 419 bereits vorgeschlagen worden, an der Unterseite des Gehäuses ein Stromwandlermodul bestehend aus drei unterschiedlichen Stromwandlern, die jeweils mit einem Einspeisekontakt verknüpft sind, bereitzustellen. Doch auch bei dieser Ausführungsform ist bei Bedarf eine entsprechende elektronische Auswertungseinrichtung mit einer Anzeigevorrichtung jeweils mit dem gewünschten Stromwandler zu verbinden. Auswertungseinrichtungen und insbesondere Anzeigevorrichtungen sind teuer und lassen sich nicht in den Schaltschränken montieren, sondern werden nur bei Bedarf mit dem entsprechenden Stromwandler verbunden.

In jedem Fall ist es aber notwendig, dass ein Techniker vor Ort den Stromwandler mit der Auswerte- und Anzeigevorrichtung verbindet, um festzustellen, wie viel Strom über den entsprechenden Abgang abgegriffen wird. Die bekannten Ausführungsformen erlauben auch nur die Anzeige einer einzigen Kenngröße, wie z. B. der erfassten Stromstärke. Die Anzeige von anderen Kenngrößen ist entweder nicht möglich oder nur als Alternative möglich, so dass eine gleichzeitige Überwachung von mehreren Kenngrößen nicht durchgeführt werden kann.

Die DE 100 319 64 beschreibt einen Leistungsschalter, mit welchem eine Last von einer Stromquelle getrennt werden kann, wenn eine Stromerfassungseinrichtung feststellt, dass ein vorbestimmter Stromwert überschritten wird. Die EP 2 181 907 A1 beschreibt ein Weichendiagnosesystem, mit dem elektrische Messgrößen einer Antriebsverkabelung von Weichen gemessen werden können. Die DE 203 04 461 beschreibt einen elektronischen Messwertumformer mit integriertem Stromwandler.

Ausgehend von dem beschriebenen Stand der Technik ist es Aufgabe der vorliegenden Erfindung, einen NH-Sicherungslasttrenner oder eine NH-Sicherungsschaltleiste der eingangs genannten Art zur Verfügung zu stellen, die eine Ermittlung der relevanten Kenngrößen auf einfache Weise erlaubt.

Erfindungsgemäß wird diese Aufgabe durch ein Stromwandlersystem gelöst, mit einem Stromwandler, mit dem der vom Einspeisekontakt zum Abgangskontakt fließenden Strom erfasst werden kann und diesen in eine Messspannung umwandelt, und einer Auswerteelektronik, welche auf Basis der Messspannung zumindest eine der Kenngrößen aus der Gruppe G, die besteht aus I, Iₙ, Ist, Iₘᵢₙ, I_{TR}, I_{MAX}, U, Uₙ, f, fₙ, PF, ermittelt, wobei I = den Stromwandler durchfließender elektrischer Strom; Iₙ = angegebene Referenzstromstärke, für die der Stromwandler ausgelegt wurde; Iₛₜ = niedrigster angegebener Wert von I, bei dem der Stromwandler bei Leistungsfaktor Eins eine elektrische Wirkenergie misst; Iₘᵢₙ = Wert von I, oberhalb dessen die Abweichung innerhalb der Fehlergrenzen liegt; Iₜᵣ = Wert von I, oberhalb dessen die Abweichung innerhalb der niedrigsten Fehlergrenzen liegt, die der für das Stromwandlersystem angegebenen Genauigkeitsklasse entsprechen; Iₘₐₓ = Höchstwert von I, bei dem die Abweichung innerhalb der Fehlergrenzen liegt; U = an dem Stromwandler anliegende elektrische Spannung; Uₙ = angegebene Bezugsspannung; f = Frequenz der an den Stromwandler anliegenden Spannung; fₙ = angegebene Bezugsfrequenz; PF = Leistungsfaktor = cosϕ = Kosinus der Phasenverschiebung ϕ zwischen I und U.

Mit anderen Worten weist das Stromwandlersystem nicht nur den eigentlichen Stromwandler auf, sondern zugleich eine Auswerteelektronik, welche zumindest einer der Kenngrößen aus der Gruppe G bestimmt.

In einer bevorzugten Ausführungsform ermittelt die Auswerteelektronik zumindest zwei der Kenngrößen aus der Gruppe G und am besten alle der genannten Kenngrößen.

Das Stromwandlersystem kann vorzugsweise eine Bussystem-Anschlussklemme aufweisen, über die das Stromwandlersystem mit einem Bussystem verbindbar ist, sodass hierüber die ermittelten Kenngrößen übertragen werden können.

Es ist somit möglich, die Sicherungslasttrenner und Sicherungsschaltleiste mit einem Bussystem zu verbinden, sodass über einen ebenfalls mit dem Bus verbundenen Computer, der beispielsweise bei dem Energieversorger angeordnet sein kann und daher nicht unbedingt in der Nähe des Schaltschrankes sein muss, die entsprechenden Kenngrößen ausgelesen werden können. Dadurch können mehrere Kenngrößen gleichzeitig über einen längeren Zeitraum überwacht werden, ohne dass die Anwesenheit eines Technikers vonnöten ist.

Insbesondere dann, wenn mehrere Trenner oder Leisten überwacht werden sollen, ist mit Vorteil jedem NH-Sicherungslasttrenner oder jeder NH-Sicherungsschaltleiste und am besten jedem Abgangskontakt der Sicherungslasttrenner oder Sicherungsschaltleiste eine eigene Identifikationsadresse zugeordnet, sodass an einem entfernten Ort, zum Beispiel bei dem Energieversorger, die Kenngrößen für jeden einzelnen Abgangskontakt leicht erfasst werden können, ohne dass es notwendig ist, dass ein Techniker vor Ort die entsprechende Auswerteelektronik vorübergehend anschließt.

Alternativ oder in Kombination ist es auch möglich, dass das Stromwandlersystem einen Anschluss für eine Anzeigevorrichtung aufweist. Die Anzeigevorrichtung kann dann die entsprechenden Kenngrößen auf einer Anzeige darstellen. Es versteht sich, dass der Anschluss für eine Anzeigevorrichtung nicht nur die ermittelten Kenngrößen übermitteln muss, sondern zudem die Energieversorgung für die Anzeigevorrichtung bereitstellen muss. Dadurch kann bei Bedarf auch ein Techniker vor Ort die gewünschten Kenngrößen auslesen.

In einer weiteren bevorzugten Ausführungsform weist das Stromwandlersystem sogar eine Anzeigevorrichtung zur Anzeige der ermittelten Kenngrößen auf, sodass es nicht notwendig ist, ein entsprechendes Display anzuschließen.

Weiterhin hat es sich gezeigt, dass der Stromwandler möglichst den Abgangskontakt umgebend anzuordnen ist, da hier das entsprechende Bussystem und gegebenenfalls eine Anzeigevorrichtung leicht angeschlossen werden können. Mit anderen Worten dient der Abgangskontakt - oder ein direkt am Abgangskontakt angeschlossenes Element - als Primärleiter für den Stromwandler.

Das Stromwandlersystem ist entweder in dem Gehäuse des Sicherungslasttrenners bzw. der Sicherungsschaltleiste aufgenommen oder weist ein eigenes Gehäuse auf, in dem die einzelnen Bestandteile des Stromwandlersystems aufgenommen sind.

In einer bevorzugten Ausführungsform ist eine Auslöseüberwachung für den zumindest einen Sicherungseinsatz vorgesehen, die vorzugsweise ebenfalls in dem Gehäuse angeordnet wird. Die Auslöseüberwachung kann ebenfalls über den Busanschluß ausgelesen werden.

Dadurch kann nun sogar von einem entfernten Ort, zum Beispiel beim Standort des Energieversorgers, festgestellt werden, welcher Sicherungseinsatz ausgelöst hat, sodass eine Fehlersuche deutlich vereinfacht wird.

Weitere Vorteile, Merkmale und Anwendungsmöglichkeiten werden deutlich anhand der folgenden Beschreibung einer bevorzugten Ausführungsform sowie der dazugehörigen Figuren. Es zeigen:
Figur 1 eine schematische Darstellung eines NH-Sicherungslasttrenners mit dem erfindungsgemäßen Stromwandlersystem,
Figur 2 eine Schnittansicht eines Gehäuses eines erfindungsgemäßen Stromwandlersystems.

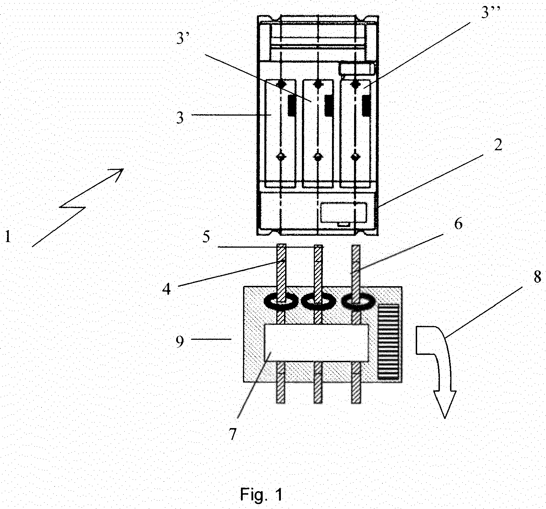

Figur 1 zeigt eine schematische Darstellung eines NH-Sicherungslasttrenners 1. Diese weist ein Gehäuse 2 auf, in dem drei Sicherungseinsätze 3, 3' und 3" angeordnet sind. An seiner Unterseite sind drei Abgangsanschlüsse 4, 5, 6 zu erkennen sowie ein Stromwandlerblock 9, der so an der Unterseite des Trenners befestigt ist, dass sich die Abgangskontakte durch diesen hindurch erstrecken. Das Stromwandlersystem 9 weist einen Anschluss 8 auf, mit dem das Wandlersystem an einem Bussystem, d.h. ein System zur Datenübertragung, angeschlossen werden kann. Die Ausführungsform weist ebenfalls eine Anzeigevorrichtung 7 auf, die in der Lage ist, die ermittelten Kenngrößen zu zeigen.

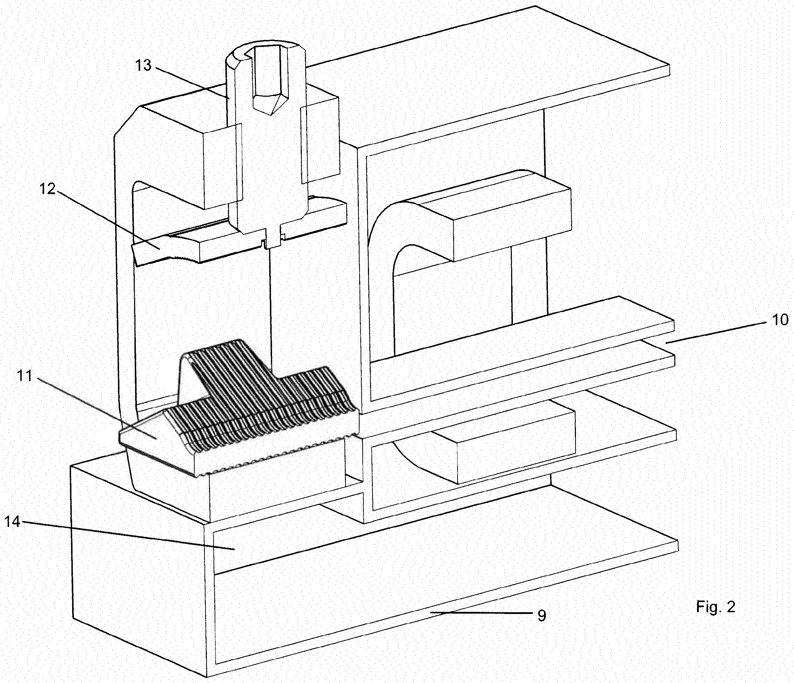

Figur 2 zeigt eine Schnittansicht durch das Stromwandlersystem von Figur 1. Das Gehäuse 2 weist eine Durchgangsöffnung 10 zur Aufnahme des entsprechenden Abgangskontaktes auf. Des Weiteren ist eine Abgangsklemme 11, 12 gezeigt, deren unteres Teil 11 mit dem in die Durchgangsöffnung 10 eingelegten Abgangskontakt in elektrischem Kontakt steht. Das obere Teil 12 kann mit Hilfe der Schraube 13 in Richtung des ersten Teils 11 bewegt werden, sodass ein entsprechendes Kabel, welches an dem Abgangskontakt befestigt werden soll, zwischen den beiden Teilen 11 und 12 eingeklemmt werden kann. Das Gehäuse weist eine Kammer 14 auf, in der die entsprechende Auswerteelektronik platziert werden kann.

### Bezugszeichenliste

- 1: N H-Sicherungslasttrenner
- 2: Gehäuse
- 3, 3', 3": Sicherungseinsätze
- 4: Abgangsanschluss
- 5: Abgangsanschluss
- 6: Abgangsanschluss
- 7: Anzeigevorrichtung
- 8: Anschluss
- 9: Gehäuse
- 10: Durchgangsöffnung
- 11: Abgangsklemme
- 12: Abgangsklemme
- 13: Schraube
- 14: Kammer

## Patentansprüche

1. NH-Sicherungslasttrenner oder NH-Sicherungsschaltleiste mit einem Gehäuse (2) mit einer Bodenfläche und mindestens einem Einspeisekontakt, der über die Bodenfläche vorsteht, und mindestens einem Abgangskontakt, zumindest einem Sicherungseinsatz (3, 3', 3"), welcher im eingesetzten Zustand den Einspeisekontakt mit dem Abgangskontakt verbindet, und einem Stromwandlersystem mit einem Stromwandler, der einen durch den Stromwandler fließenden Strom erfasst und in eine Messspannung umwandelt, **gekennzeichnet durch** eine Auswerteelektronik, welche auf Basis der Messspannung zumindest eine der Kenngrößen aus der Gruppe G, die besteht aus I, Iₙ, Iₛₜ, Iₘᵢₙ, I_{TR}, I_{MAX}, U, Un, f, fₙ, PF, ermittelt, wobei
I = den Stromwandler durchfließender elektrischer Strom;
Iₙ = angegebene Referenzstromstärke, für die der Stromwandler ausgelegt wurde;
Iₛₜ = niedrigster angegebener Wert von I, bei dem der Stromwandler bei Leistungsfaktor Eins eine elektrische Wirkenergie misst;
Iₘᵢₙ = Wert von I, oberhalb dessen die Abweichung innerhalb der Fehlergrenzen liegt;
Iₜᵣ = Wert von I, oberhalb dessen die Abweichung innerhalb der niedrigsten Fehlergrenzen liegt, die der für das Stromwandlersystem angegebenen Genauigkeitsklasse entsprechen;
Iₘₐₓ = Höchstwert von I, bei dem die Abweichung innerhalb der Fehlergrenzen liegt;
U = an dem Stromwandler anliegende elektrische Spannung;
Uₙ = angegebene Bezugsspannung;
f = Frequenz der an den Stromwandler anliegenden Spannung;
fₙ = angegebene Bezugsfrequenz;
PF = Leistungsfaktor = cosϕ = Kosinus der Phasenverschiebung ϕ zwischen I und U, wobei der Stromwandler den Abgangskontakt umgebend angeordnet ist und
das Stromwandlersystem ein Wandlergehäuse (9) aufweist, in dem die einzelnen Bestandteile des Stromwandlersystems aufgenommen sind.

2. NH-Sicherungslasttrenner oder NH-Sicherungsschaltleiste nach Anspruch 1,**dadurch gekennzeichnet, dass** drei Einspeisekontakte und drei Abgangskontakte vorgesehen sind und das Stromwandlersystem drei Stromwandler aufweist, wobei jeder Stromwandler einen Abgangskontakt umgebend angeordnet ist.

3. NH-Sicherungslasttrenner oder NH-Sicherungsschaltleiste nach einem der Ansprüche 1 bis 2, **dadurch gekennzeichnet, dass** eine Auslöseüberwachung für den zumindest einen Sicherungseinsatz in dem Wandlergehäuse (9) vorgesehen ist.

4. NH-Sicherungslasttrenner oder NH-Sicherungsschaltleiste nach einem der Ansprüche 1 bis 3, **dadurch gekennzeichnet, dass** die Auswerteelektronik zumindest zwei der Kenngrößen aus der Gruppe G ermittelt.

5. NH-Sicherungslasttrenner oder NH-Sicherungsschaltleiste nach einem der Ansprüche 1 bis 4, **dadurch gekennzeichnet, dass** das Stromwandlersystem eine Bussystem-Anschlußklemme aufweist, über die das Stromwandlersystem mit einem Bussystem verbindbar ist und die ermittelten Kenngrößen übertragen werden können.

6. NH-Sicherungslasttrenner oder NH-Sicherungsschaltleiste nach einem der Ansprüche 1 bis 5, **dadurch gekennzeichnet, dass** ein Anschluss für eine Anzeigevorrichtung vorgesehen ist.

7. NH-Sicherungslasttrenner oder NH-Sicherungsschaltleiste nach einem der Ansprüche 1 bis 6, **dadurch gekennzeichnet, dass** eine Anzeigevorrichtung zur Anzeige der ermittelten Kenngrößen vorgesehen ist.

## Claims

1. An NH fuse switch disconnector or NH fuse switch rail having a housing (2) with a bottom surface and at least one feed-in contact which projects beyond the bottom surface and at least one outgoing contact, at least one fuse insert (3, 3', 3") which in the inserted condition connects the feed-in contact to the outgoing contact, and a current transformer system comprising a current transformer which detects a current flowing through the current transformer and converts it into a measurement voltage, **characterised by** an electronic evaluation means which on the basis of the measurement voltage ascertains at least one of the parameters from the group G comprising I, In, Iₛₜ, Iₘᵢₙ, I_{TR}, I_{MAX}, U, Uₙ, f, fₙ and PF, wherein
I = electric current flowing through the current transformer,
Iₙ = specified reference current strength for which the current transformer was designed,
Iₛₜ = lowest specified value of I, at which the current transformer measures an electrical active energy at a power factor of one,
Iₘᵢₙ = value of I, above which the deviation is within the error limits,
Iₜᵣ = value of I, above which the deviation is within the lowest error limits which correspond to the accuracy class specified for the current transformer system,
Iₘₐₓ = highest value of I at which the deviation is within the error limits,
U = electric voltage at the current transformer,
Uₙ = specified reference voltage,
f = frequency of the voltage at the current transformer,
fₙ = specified reference frequency, and
PF = power factor = cosϕ = cosine of the phase shift ϕ between I and U,
wherein the current transformer is arranged surrounding the outgoing contact, and the current transformer system has a transformer housing (9) in which the individual components of the current transformer system are accommodated.

2. An NH fuse switch disconnector or NH fuse switch rail according to claim 1 **characterised in that** there are provided three feed-in contacts and three outgoing contacts and the current transformer system has three current transformers, wherein each current transformer is arranged surrounding an outgoing contact.

3. An NH fuse switch disconnector or NH fuse switch rail according to one of claims 1 and 2 **characterised in that** there is provided a triggering monitoring means for the at least one fuse insert in the transformer housing (9).

4. An NH fuse switch disconnector or NH fuse switch rail according to one of claims 1 to 3 **characterised in that** the electronic evaluation means ascertains at least two of the parameters from the group G.

5. An NH fuse switch disconnector or NH fuse switch rail according to one of claims 1 to 4 **characterised in that** the current transformer system has a bus system connection terminal, by way of which the current transformer system can be connected to a bus system and the ascertained parameters can be transmitted.

6. An NH fuse switch disconnector or NH fuse switch rail according to one of claims 1 to 5 **characterised in that** there is provided a connection for a display device.

7. An NH fuse switch disconnector or NH fuse switch rail according to one of claims 1 to 6 **characterised in that** there is provided a display device for displaying the ascertained parameters.

## Revendications

1. Sectionneur de charge NH ou barre de commutation NH avec un boîtier (2) ayant une surface de fond et au moins un contact d'entrée qui est proéminent par rapport à la surface de fond, et avec au moins un contact de sortie, au moins une cartouche de fusible (3, 3', 3") qui, en état inséré, connecte le contact d'entrée au contact de sortie, et avec un système transducteur de courant ayant un transducteur de courant qui détecte un courant passant par le transducteur de courant et le transforme en une tension de mesure, **caractérisé par** une électronique d'exploitation qui, sur la base de la tension de mesure, détermine au moins une des grandeurs du groupe G consistant en I, Iₙ, Iₛₜ, Iₘᵢₙ, I_{TR,} I_{MAX}, U, Uₙ, f, fₙ, PF, où
I = courant électrique passant par le transducteur de courant,
Iₙ = courant de référence indiqué pour lequel le transducteur a été conçu,
Iₛₜ = valeur minimale indiquée à laquelle le transducteur mesure, pour un facteur de puissance un, une énergie effective électrique,
Iₘᵢₙ = valeur d'I au-dessus de laquelle la dérivation est dans les limites de tolérance,
Iₜᵣ = valeur d'I au-dessus de laquelle la dérivation est dans les limites les plus petites qui correspondent à la classe de précision indiquée pour le système transducteur de courant,
Iₘₐₓ = valeur maximale d'I à laquelle la dérivation est dans les limites de tolérance,
U = tension appliquée au transducteur de courant,
Un = tension de référence indiquée,
f = fréquence de la tension appliquée au transducteur de courant,
fₙ = fréquence de référence indiquée,
PF = facteur de puissance = cos ϕ = cosinus du décalage de phase ϕ entre I et U,
le transducteur étant disposé de façon à entourer le contact de sortie et
le système transducteur comprenant un boîtier de transducteur (9) dans lequel sont reçus les différents composants du système transducteur.

2. Sectionneur de charge NH ou barre de commutation NH selon la revendication 1, **caractérisé en ce que** sont prévus trois contacts d'entrée et trois contacts de sortie et que le système transducteur comprend trois transducteurs, chaque transducteur étant disposé de façon à entourer un contact de sortie.

3. Sectionneur de charge NH ou barre de commutation NH selon l'une des revendications 1 à 2, **caractérisé en ce qu'**il est prévu une surveillance de déclenchement pour ladite au moins une cartouche de fusible dans le boîtier de transducteur (9).

4. Sectionneur de charge NH ou barre de commutation NH selon l'une des revendications 1 à 3, **caractérisé en ce que** l'électronique d'exploitation détermine au moins deux des grandeurs du groupe G.

5. Sectionneur de charge NH ou barre de commutation NH selon l'une des revendications 1 à 4, **caractérisé en ce que** le système transducteur comprend une borne de raccordement de système de bus par laquelle le système transducteur peut être raccordé au système de bus et via laquelle les grandeurs déterminées peuvent être transmises.

6. Sectionneur de charge NH ou barre de commutation NH selon l'une des revendications 1 à 5, **caractérisé en ce qu'**il est prévu une connexion pour un système d'affichage.

7. Sectionneur de charge NH ou barre de commutation NH selon l'une des revendications 1 à 6, **caractérisé en ce qu'**il est prévu un dispositif d'affichage pour l'affichage des grandeurs déterminées.
